Europäisches Patentamt

European Patent Office

Office européen des brevets

(19)

(11) Veröffentlichungsnummer: **0 340 520 B1**

## (12) EUROPÄISCHE PATENTSCHRIFT

(45) Veröffentlichungstag der Patentschrift: **02.12.92**

(51) Int. Cl.⁵: **H05K 7/20**

(21) Anmeldenummer: **89106879.3**

(22) Anmeldetag: **17.04.89**

(54) **Anordnung zur konvektiven Kühlung von elektronischen Bauelementen, insbesondere von integrierten Halbleiterschaltungen.**

(30) Priorität: **05.05.88 DE 3815387**

(43) Veröffentlichungstag der Anmeldung:
**08.11.89 Patentblatt 89/45**

(45) Bekanntmachung des Hinweises auf die
Patenterteilung:
**02.12.92 Patentblatt 92/49**

(84) Benannte Vertragsstaaten:
**AT BE CH DE FR GB IT LI NL**

(56) Entgegenhaltungen:

**IBM TECHNICAL DISCLOSURE BULLETIN. vol. 24, no. 11a, April 1982, NEW YORK US Seiten 5625 - 5626; M. E. Ecker, K. Grebe: "Separable mercury wetted thermal interface for multi-chip carriers"**

(73) Patentinhaber: **Siemens Nixdorf Informationssysteme AG
Otto-Hahn-Ring 6
W-8000 München 83(DE)**

(72) Erfinder: **Richter, Hans-Jürgen, Dipl.-Ing.
Moosen 23
W-8201 Riedering(DE)**

(74) Vertreter: **Fuchs, Franz-Josef, Dr.-Ing. et al
Postfach 22 13 17
W-8000 München 22(DE)**

## Beschreibung

Die Erfindung betrifft eine Anordnung zur konvektiven Kühlung von in Gruppen auf Leiterplatten angeordneten elektronischen Bauelementen, insbesondere von integrierten Halbleiterschaltungen, mit einem Kühlkörper, der aus zwei übereinander angeordneten Teilen zusammengesetzt ist, wobei der untere Teil auf den zu kühlenden Baulementen angeordnet ist und der obere Teil zum Wärmeaustausch mit einem umgebenden Gas Strukturen mit großer Oberfläche aufweist.

Durch die zunehmende Miniaturisierung elektronischer Bauelemente, bzw. die steigende Integrationsdichte integrierter Schaltungen liegen die anfallenden Verlustleistungen von Leistungsbauelementen heute bei bis zu $1 \times 10^6$ W/m$^2$. Zur Kühlung elektronischer Bauelemente mit niedriger bis mittlerer Verlustleistung sind Kühlanordnungen, die auf dem Prinzip der Luftkühlung beruhen, geeignet und zeichnen sich im allgemeinen durch einen einfachen Aufbau und eine hohe Zuverlässigkeit aus.

In Mechanical Engineering, März 1986, S. 35-42 sind einige Anordnungen zur Luftkühlung von Bauelementen beschrieben. Eine Anordnung zur Luftkühlung eines einzelnen Bauelements, die sich durch einen besonders einfachen Aufbau auszeichnet, ist ein auf das Bauelement mittels eines gut wärmeleitenden Epoxid-Klebstoffes aufgebrachter Kühlkörper, der aus mehreren Kühlrippen besteht. Eine Anordnung gemäß dem Oberbegriff weist einen zweiteiligen Kühlkörper auf, dessen auf den zu kühlenden Bauelementgruppen angeordneter unterer Teil eine mit Wasserstoff gefüllte Keramikform und dessen oberer Teil eine auf die Keramikform aufgeklebte Kühlrippen tragende Kappe ist. Diese Anordnung hat den Nachteil, daß aufgrund der Verwendung starrer, unelastischer Werkstoffe die Wärmeleitung an der Grenzfläche Bauelementoberfläche-Kühlkörper ungenügend ist, da das Keramikteil des Kühlkörpers nicht direkt auf den zu kühlenden Bauelementen aufliegt. Zur Erhöhung der Wärmeabstrahlung sind daher Kupferplatten als Wärmeverteiler auf jedes Bauelement aufgelötet. Da nur im Idealfall ebener Bauelementoberflächen die Spalte zwischen Bauelementoberfläche und Kühlkörper vernachlässigbar klein gehalten werden können, ist die Anordnung zur gemeinsamen Kühlung von Bauelementgruppen, die Bauelemente unterschiedlichster geometrischer Formen aufweisen, nicht geeignet.

Aufgabe der Erfindung ist es daher, eine Anordnung zur konvektiven Kühlung von in Gruppen auf Leiterplatten angeordnete elektronischen Bauelementen anzugeben, die für alle Bauelementformen und für Gruppen von Bauelementen mit verschiedenster Zusammensetzung geeignet ist.

Diese Aufgabe wird mit einer Anordnung der eingangs genannten Art dadurch gelöst, daß

a) der untere Teil des Kühlkörpers aus zwei übereinander angeordneten, mindestens im Randbereich fest miteinander verbundenen Kunststoff-Metall-Verbundfolien gebildet ist,

b) die auf den zu kühlenden Bauelementen angeordnete Kunststoff-Metall-Verbundfolie durch Tiefziehen geschaffener Ausformungen aufweist, die der Lage und Form der Bauelemente angepasst und mit einem gut wärmeleitenden, flexiblen Material gefüllt sind und

c) der obere Teil des Kühlkörpers eine Platte ist, die auf der den Bauelementen abgewandten Seite die Strukturen mit großer Oberfläche aufweist.

Durch Verwendung einer tiefgezogenen Kunststoff-Metall-Verbundfolie, deren Ausformungen der Lage und Form der Bauelemente angepasst sind, ist somit ein direkter Wärmekontakt vom Kühlkörper zu den Bauelementen hergestellt, der sich durch eine besonders gute Wärmeableitung auszeichnet. Besonders vorteilhafte Ausgestaltung der Erfindung weisen eine Kunststoff-Metall-Verbundfolie mit der Schichtenfolge Polypropylen, Aluminium, Polypropylen oder eine Kunststoff-Metall-Verbundfolie mit einer äußeren, den Bauelementen zugewandten Schicht aus Polyimid auf.

Solche Verbundfolien haben besonders gute Tiefzieheigenschaften und eine gute Kerbfestigkeit bei gleichzeitig guter Wärmeleitfähigkeit.

Weitere Vorteile der Anordnung sind der geringe Verlust an effektiver Bestückungsfläche der die Bauelemente tragenden Leiterplatte und die geringen äußeren Maße der gesamten Kühlanordnung aufgrund der optimalen Anpassung des Kühlkörpers an die Oberfläche der zu kühlenden Bauelementgruppen.

Weitere Ausgestaltungen der Erfindung ergeben sich aus den Unteransprüchen und der anhand eines Ausführungsbeispiels mit zwei FIG gegebenen Beschreibung.

FIG 1

Eine Anordnung zur konvektiven Kühlung einer auf einer Leiterplatte 2 befindlichen Gruppe elektronischer Bauelemente 8 ist als Draufsicht mit geöffnetem Kühlkörper 7 schematisch dargestellt. Auf der Leiterplatte 2, die mit verschiedenartigen Bauelementen 8 bestückt ist, ist ein Kühlkörper 7 angeordnet, der auf der den zu kühlenden Bauelementen abgewandten Seite zum Wärmeaustausch mit einem umgebenden Gas eine Außentruktur 5 mit großer Oberfläche aufweist. Diese Außenstruktur 5 ist im einfachsten Fall aus der Wärmetechnik allgemein bekannte Kühlrippen. Der Kühlkörper 7 ist durch Schrauben 6 an einen Klemmrahmen 15 befestigt, der die Leiterplatte 2 umspannt. Dadurch drückt der Kühlkörper 7 elastisch auf die Bauelemente 8. Die Anordnung ist neben einem Betrieb mit freier, natürlicher Luftkonvektion auch zum Betrieb mit erzwungener Konvektion durch Leiten eines Gases über die Oberfläche der Strukturen 5 geeignet.

FIG 2

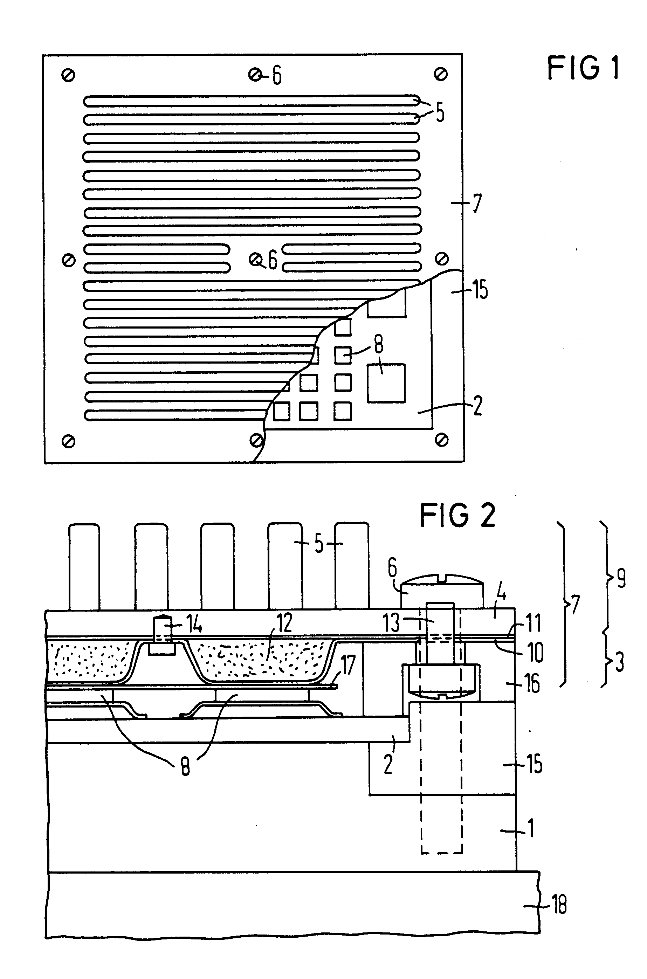

Die schematische Darstellung zeigt einen Ausschnitt eines Schnittes der Anordnung aus FIG 1. Dabei ist die mit Bauelementen 8 bestückte Leiterplatte 2 parallel zu einer Trägerleiterplatte 18 angeordnet, mit der sie über einen PGA-Stecker 1 (PGA = Pin Grid Array) verbunden ist. Die Bauelemente 8 sind optional mit einer Schutzfolie 17 bedeckt, die zum Schutz des Kühlkörpers 7 gegen scharfkantige Bauelemente oder bei Verwendung einer Metallfolie zum Anlegen eines konstanten elektrischen Potentials an die Bauelementoberfläche eingesetzt werden kann.

Der Kühlkörper 7 weist zwei übereinander angeordnete Teile 9, 3 aus gut wärmeleitenden Materialien auf, die im Randbereich durch Schrauben 13 miteinander verbunden sind. Dabei ist zwischen der Leiterplatte 2 und der unteren Kunststoff-Metall-Verbundfolie 10 ein Distanzstück 16 vorgesehen, dessen Höhenabmessung von der maximalen Höhe der Bauelemente 8 abhängt und die Maße der Ausformungen 12 bedingt. Der obere Teil 9 des Kühlkörpers 7 ist eine Platte 4, die Kühlrippen 5 trägt. Der untere Teil 3 des Kühlkörpers 7 ist aus zwei Kunststoff-Metall-Verbundfolien 10, 11 gebildet, wobei die untere Kunststoff-Metall-Verbundfolie 10 durch Vakuum-Tiefziehen geschaffene Ausformungen 12 aufweist, die mit einem gut wärmeleitfähigen flexiblen Material gefüllt sind. Die Platte 4 hat die Aufgabe, den unteren Kühlkörper-Teil 3 seiner insgesamt flexiblen Außenkontur und Füllung gegen die Bauelement-Anordnung zu pressen.

Als Feststoff-Füllung kann z.B. ein Aluminium-,Kupferverbindungen oder Graphit enthaltendes Pulver oder Granulat, eine hochviskose Wärmeleitpaste oder ein gefülltes gut wärmeleitendes Elastomer verwendet werden.

Außerdem ist es möglich und vorteilhaft, als Füllung Gas zu verwenden, wobei es erforderlich ist, die beiden Kunststoff-Metall-Verbundfolien 10, 11 mindestens im Randbereich entlang des Umfangs und and den Durchbohrungen für die Haltestifte gasdicht miteinander zu verbinden. Dabei kann eine optimale Dichtigkeit durch Verschweißen der Metall-Schichten der Kunststoff-Metall-Verbundfolien 10, 11 erreicht werden. Ein gasdichtes Verschließen jeder einzelnen Ausformungen 12 durch Verschweißen erhöht die Sicherheit der Kühlanordnung gegen Schäden durch Leckwerden.

Die Kunststoff-Metall-Verbundfolien 10, 11 weisen die Schichtenfolge Polypropylen, Aluminium, Polypropylen auf. Die Polypropylenschichten sind ca. 20 Mikrometer dick, die Aluminiumschicht ist ca. 85 Mikrometer dick. Die Zusammensetzung der Kunststoff-Metall-Verbundfolie ist so gewählt, daß sie gute Tiefzieheigenschaften bei gleichzeitiger guter Wärmeleitfähigkeit aufweist. Die Ausformungen 12 der unteren Metallverbundfolie 10 sind durch Vakuum-Tiefziehen so geschaffen, daß sie der Form und Lage der zu kühlenden Bauelemente 8 angepasst sind.

Der Kühlkörper 7 ist mit dem Distanzstück 16 durch Schrauben 6 an den Klemmrahmen 15 befestigt, der die Leiterplatte 2 fest umspannt. Bei großen zu kühlenden Oberflächen von Bauelementgruppen 2 kann es vorteilhaft sein, die Kunststoff-Metall-Verbundfolien 10, 11 zusätzlich zur Befestigung im Randbereich an einer oder mehreren Stellen zwischen den Ausformungen 12 mit Haltestiften 14 an den oberen Teil des Kühlkörpers 9 festzustecken, damit ein Durchhängen des unteren Teils 3 des Kühlkörpers 7 vermieden ist. Die für einen optimalen (minimalen) Wärmewiderstand nötige, über geeignete Maßverhältnisse eingebrachte Flächenpressung zwischen Bauelement 8, ggf. Folie 17 und Ausformung 12 erfordert eine vertikale Deformation der Ausformung 12, die dank ihrer Flexibilität lateral ausweichen kann, ohne die Bauelemente 8 durch zu hohe Kräfte zu schädigen.

Die Anordnung ist für alle gängigen Formen der Baugruppen-Bestückung und Montage der Leiterplatten auf Hauptverdrahtungs-Leiterplatten geeignet. Die Erfindung beinhaltet auch eine Anordnung zur konvektiven Kühlung von auf beiden Seiten einer Leiterplatte angeordneten Bauelementen, wobei auf beiden Seiten dieser Leiterplatte jeweils ein Kühlkörper auf den zu kühlenden Bauelementen angeordnet ist und die Kühlkörper mit einem gemeinsamen Klemmrahmen an der Leiterplatte befestigt sind (nicht in den FIG dargestellt), z. B. bei einer beidseitigen Huckepack (=babyboard)-Montage.

Gleiche Teile sind in den FIG mit demselben Bezugszeichen versehen. Die schematischen Darstellungen sind nicht als Maßstabsgetreu zu betrachten.

**Patentansprüche**

1. Anordnung zur konvektiven Kühlung von in Gruppen auf Leiterplatten angeordneten elektronischen Bauelementen, insbesondere von integrierten Halbleiterschaltungen, mit einem Kühlkörper, der aus zwei übereinander angeordneten Teilen zusammengesetzt ist, wobei der untere Teil auf den zu kühlenden Bauelementen angeordnet ist und der obere Teil zum Wärmeaustausch mit einem umgebenden Gas Strukturen mit großer Oberfläche aufweist, **dadurch gekennzeichnet, daß**

a) der untere Teil (3) des Kühlkörpers (7) aus zwei übereinander angeordneten, mindestens im Randbereich fest miteinander verbundenen Kunststoff-Metall-Verbundfolien (10, 11) gebildet ist,

b) die auf den zu kühlenden Bauelementen (8) angeordnete Kunststoff-Metall-Verbundfolie (10) durch Tiefziehen geschaffene Ausformungen (12) aufweist, die der Lage und Form der Bauelemente (8) angepasst und mit einem gut wärmeleitenden, flexiblen Material gefüllt sind und

c) der obere Teil (9) des Kühlkörpers (7) eine Platte (4) ist, die auf der den Bauelementen (8) abgewandten Seite die Strukturen (5) mit großer Oberfläche aufweist.

2. Anordnung nach Anspruch 1, **dadurch gekennzeichnet, daß** die Kunststoff-Metall-Verbundfolie (10, 11) die Schichtenfolge Polypropylen, Aluminium, Polypropylen aufweist.

3. Anordnung nach Anspruch 1 oder 2, **dadurch gekennzeichnet, daß** die Kunststoff-Metall-Verbundfolie (10) eine äußere Schicht aus Polyimid aufweist, die auf den Bauelementen (8) angeordnet ist.

4. Anordnung nach einem der Ansprüche 1 bis 3, **dadurch gekennzeichnet, daß** der Kühlkörper (7) mittels eines am äußeren Umfang der die Bauelemente (8) tragenden Leiterplatte (2) angeordneten Klemmrahmens (15) auf den Bauelementgruppen (8) elastisch andrückend befestigt ist.

5. Anordnung nach einem der Ansprüche 1 bis 4, **dadurch gekennzeichnet, daß** der untere Teil (3) des Kühlkörpers (7) am oberen Teil (9) des Kühlkörpers (7) zusätlich durch Haltestifte (14) an mindestens einer Stelle zwischen den Ausformungen (12) an der Platte (4) befestigt ist.

6. Anordnung nach einem der Ansprüche 1 bis 5, **dadurch gekennzeichnet, daß** zwischen dem Kühlkörper (7) und der Oberfläche der die Bauelementgruppen (8) tragenden Leiterplatte (2) eine Schutzfolie (17) angeordnet ist.

7. Anordnung nach einem der Ansprüche 1 bis 6, **dadurch gekennzeichnet, daß** die Strukturen (5) mit großer Oberfläche Kühlrippen sind.

8. Anordnung nach einem der Ansprüche 1 bis 7, **dadurch gekennzeichnet, daß** die Ausformungen (12) mit einem Pulver oder Granulat aus gut wärmeleitendem Material gefüllt sind.

9. Anordnung nach einem der Ansprüche 1 bis 7, **dadurch gekennzeichnet, daß** die Ausformungen (12) mit einem gut wärmeleitenden, gefüllten Elastomer gefüllt sind.

10. Anordnung nach einem der Ansprüche 1 bis 7, **dadurch gekennzeichnet, daß** die Ausformungen (12) mit einer hochviskosen Wärmeleitpaste gefüllt sind.

11. Anordnung nach einem der Ansprüche 1 bis 7, **dadurch gekennzeichnet, daß** die Ausformungen (12) mit Gas gefüllt sind und die Kunststoff-Metall-Verbundfolien (10, 11) mindestens im Randbereich entlang des Umfangs so miteinander verbunden sind, daß sie ein gasdicht abgeschlossenes Volumen bilden.

12. Anordnung nach Anspruch 11, **dadurch gekennzeichnet, daß** die Kunststoff-Metall-Verbundfolien (10, 11) so miteinander verbunden sind, daß jede einzelne Ausformung (12) gasdicht geschlossen ist.

## Claims

1. Arrangement for convectively cooling electronic components, in particular integrated semiconductor circuits, disposed in groups on printed circuit boards, comprising a heat sink which is made up of two parts disposed one on top of the other, the lower part being disposed on the components to be cooled and the upper part having structures with large surface area for heat exchange with a surrounding gas, characterised in that

a) the lower part (3) of the heat sink (7) is formed from two plastic/metal composite sheets (10, 11) disposed one on top of the other and firmly joined to one another at least in the edge region,

b) the plastic/metal composite sheet (10) disposed on the components (8) to be cooled has protrusions (12) which have been produced by deep drawing and which match the position and shape of the components (8) and are filled with a flexible material having good thermal conductivity, and

c) the upper part (9) of the heat sink (7) is a plate (4) which has the structures (5) with large surface area on the side remote from the components (8).

2. Arrangement according to Claim 1, characterised in that the plastic/metal composite sheet (10, 11) has the layer sequence polypropylene, aluminium, polypropylene.

3. Arrangement according to Claim 1 or 2, characterised in that the plastic/metal composite sheet (10) has an outer layer of polyimide which is disposed on the components (8).

4. Arrangement according to one of Claims 1 to 3, characterised in that the heat sink (7) is mounted so as to make elastic pressure contact on the component groups (8) by means of a clamping frame (15) disposed at the outer periphery of the printed circuit board (2) carrying the components (8).

5. Arrangement according to one of Claims 1 to 4, characterised in that the lower part (3) of the heat sink (7) is additionally attached to the plate (4) at the upper part (9) of the heat sink (7) by retaining pins (14) at at least one position between the protrusions (12).

6. Arrangement according to one of Claims 1 to 5, characterised in that a protective sheet (17) is disposed between the heat sink (7) and the surface of the printed circuit board (2) carrying the component groups (8).

7. Arrangement according to one of Claims 1 to 6, characterised in that the structures (5) with large surface area are cooling ribs.

8. Arrangement according to one of Claims 1 to 7, characterised in that the protrusions (12) are filled with a powder or granular material composed of material with good thermal conductivity.

9. Arrangement according to one of Claims 1 to 7, characterised in that the protrusions (12) are filled with a filled elastomer having good thermal conductivity.

10. Arrangement according to one of Claims 1 to 7, characterised in that the protrusions (12) are filled with a highly viscous heat-conducting paste.

11. Arrangement according to one of Claims 1 to 7, characterised in that the protrusions (12) are filled with gas and the plastic/metal composite sheets (10, 11) are joined to one another at least in the edge region along the periphery in such a way that they form a volume sealed in a gastight manner.

12. Arrangement according to Claim 11, characterized in that the plastic/metal composite sheets (10, 11) are joined to one another in such a way that each individual protrusion (12) is sealed in a gastight manner.

**Revendications**

1. Dispositif de refroidissement par convection de composants électroniques disposés selon des groupes sur des plaquettes à circuits imprimés, notamment des circuits intégrés à semiconducteurs, comportant un corps de refroidissement, qui est constitué de deux parties superposées, parmi lesquelles la partie inférieure est disposée sur les composants devant être refroidis et la partie supérieure possède, pour l'échange de chaleur avec un gaz environnant, des structures de surface étendues, caractérisé par le fait que

a) la partie inférieure (3) du corps de refroidissement (7) est formée par deux feuilles composites matière plastique-métal (10,11) superposées et réunies fermement entre elles au moins dans leur zone marginale,

b) la feuille composite matière plastique-métal (10), qui est disposée sur les composants (8) devant être refroidis, possède des cavités (12) formées par emboutissage, dont la position et la forme sont adaptées aux composants (8) et qui sont remplies par un matériau flexible bon conducteur de la chaleur, et

c) la partie supérieure (9) du corps de refroidissement (7) est une plaque (4), qui possède, sur la face tournée à l'opposé des composants (8), des structures (5) ayant une surface étendue.

2. Dispositif suivant la revendication 1, caractérisé en ce que la feuille composite matière plastique-métal (10, 11) possède la succession de couches polypropylène, aluminium, polypropylène.

3. Dispositif suivant la revendication 1 ou 2, caractérisé en ce que la feuille composite matière plastique-métal (10) possède une couche extérieure en polyimide, qui est disposée sur les composants (8).

4. Dispositif suivant l'une des revendications 1 à 3, caractérisé en ce que le corps de refroidissement (7) est fixé de manière à appliquer une compression élastique sur les groupes (8) de composants, au moyen d'un cadre de serrage (15) disposé sur le pourtour extérieur de la plaquette à circuits imprimés (2) portant les composants (8).

5. Dispositif suivant l'une des revendications 1 à 4, caractérisé par le fait que la partie inférieure (3) du corps de refroidissement (7) est fixée de façon supplémentaire sur la partie supérieure (9) du corps de refroidissement (7) par des tiges de retenue (14), au moins en un emplacement présent entre les cavités (12) ménagées sur la plaque (4).

6. Dispositif suivant l'une des revendications 1 à 5, caractérisé en ce qu'une feuille protectrice (17) est disposée entre le corps de refroidissement (7) et la surface de la plaquette à circuits imprimés (2) qui porte les groupes (8) de composants.

7. Dispositif suivant l'une des revendications 1 à 6, caractérisé en ce que les structures (5) de surface étendues sont des nervures de refroidissement.

8. Dispositif suivant l'une des revendications 1 à 7, caractérisé en ce que les cavités (12) sont remplies par une poudre ou des granulés formés d'un matériau conduisant bien la chaleur.

9. Dispositif suivant l'une des revendications 1 à 7, caractérisé par le fait que les cavités (12) sont remplies par un élastomère chargé, qui conduit bien la chaleur.

10. Dispositif suivant l'une des revendications 1 à 7, caractérisé en ce que les cavités (12) sont remplies par une pâte thermoconductrice très visqueuse.

11. Dispositif suivant l'une des revendications 1 à 7, caractérisé en ce que les cavités (12) sont remplies par un gaz et que les feuilles composites matière plastique-métal (10,11) sont reliées entre elles au moins dans la zone marginale le long du pourtour de manière à former un volume fermé étanche au gaz.

12. Dispositif suivant la revendication 11, caractérisé en ce que les feuilles composites matière plastique-métal (10,11) sont reliées entre elles de telle sorte que chaque cavité individuelle (12) est fermée d'une manière étanche au gaz.

FIG 1

FIG 2